Europäisches Patentamt

European Patent Office

Office européen des brevets

(11) Publication number: **0 154 629**
**B1**

(12) # EUROPEAN PATENT SPECIFICATION

(45) Date of publication of patent specification: **17.01.90**

(21) Application number: **84902867.5**

(22) Date of filing: **02.07.84**

(86) International application number:
**PCT/US84/01059**

(87) International publication number:
**WO 85/01031 14.03.85 Gazette 85/07**

(51) Int. Cl.⁵: **B 65 D 73/02, B 65 D 85/02,
B 65 D 85/42, B 65 D 85/48,
B 32 B 31/00, B 65 B 3/04,
B 65 B 23/00, B 65 B 59/00,
B 65 B 61/20, E 04 F 15/16**

(54) **DUSTFREE PACKAGING CONTAINER AND METHOD.**

(30) Priority: **29.08.83 US 527251**

(43) Date of publication of application:
**18.09.85 Bulletin 85/38**

(45) Publication of the grant of the patent:
**17.01.90 Bulletin 90/03**

(84) Designated Contracting States:
**AT BE CH DE FR GB LI LU NL SE**

(56) References cited:
| | |
|---|---|
| DE-A-2 016 869 | US-A-3 615 006 |
| JP-A-55 049 254 | US-A-3 668 658 |
| US-A-2 030 135 | US-A-3 810 812 |
| US-A-3 500 129 | US-A-3 911 937 |
| US-A-3 564 811 | US-A-4 343 964 |

IBM TECHNICAL DISCLOSURE BULLETIN, vol.
20, no. 6, November 1977, page 2207, New York,
US; R.W. MARTIN et al.: "Glass mask protection
and particulate cleaning"

(73) Proprietor: **YEN, Yung-Tsai
1192 St. Anthony Court
Los Altos, CA 94022 (US)**

(72) Inventor: **YEN, Yung-Tsai
1192 St. Anthony Court
Los Altos, CA 94022 (US)**

(74) Representative: **Enskat, Michael Antony Frank
et al
Michael A. Enskat & Co. 9, Rickmansworth Road
Watford Hertfordshire WD1 7HE (GB)**

(56) References cited:
**IBM TECHNICAL DISCLOSURE BULLETIN, vol.
23, no. 11, April 1981, pages 4934-4935, New
York, US; L.G. COOK et al.: "Light-weight
cleanable mask container"**

**Western Electric Technical Digest No. 15
Published Juli 1969**

EP 0 154 629 B1

## Description

The present invention relates to packaging containers for shipment and storage and to a method of packaging in which particulate contamination is designed to be minimized. The predominant current usage of the present invention relates to prevention of dust contamination of surfaces of products, particularly in the electronic and optical fields.

Protective packaging of materials and products has been practiced since time immemorial. There has always been a need to prevent contamination and damage to products being stored or transported. However, the needs for protective packaging in recent years have become ever more stringent.

The electronics industry, in particular, has made increasing demands upon the the quality of packaging of various components utilized in manufacture and also regarding finished product shipping. The microminiature aspects of the components utilized in the modern electronics field have made it possible for a very small amount of contamination to cause significant problems. Therefore, any contamination at all must be carefully avoided.

One improvement in modern electronics packaging, as compared to conventional packaging, is the use of entirely non-shedding packaging materials. Plastics such as polyurethane, polyethylene and other massive molecular structure compositions have been utilized to minimize the opportunity for contamination of the product by particles separating from the packaging material itself. Furthermore, the actual packing of products takes place under extremely well controlled conditions in a totally contamination-free environment. However, even the best of conditions and materials still allow for some slight possibility of particulate contamination.

To date, no entirely satisfactory means of packaging has been introduced which, for all intents and purposes eliminates particulate contamination as well as satisfying the other requirements of industry-acceptable packaging. These requirements include economical manufacture, ease of use, low weight, resistance to degradation under electronic equipment conditions stackability, and aesthetic qualities.

US Patent No. 3,911,937 discloses a compressed gas insulated system in which an adherent or sticky coating is provided on selected surfaces areas inside the compressed-gas-insulated system to trap or captivate conducting and non-conducting particles, which if allowed to remain free can promote breakdown of metallic parts or electrodes maintained at different potentials or tracking and flashover along insulated surfaces. The coating may be hardened before the system is put into use to lock-in captured particles.

In this arrangement the container, on which the adherent or sticky coating is coated, is integral with the device. US Patent No. 4,343,964 also shows a device having an integral container coated with an adherent or sticky coating.

Any collected contamination remains in the device to be protected and cannot be removed from the device.

It is an object of the invention to provide an improved packaging container and an improved method of packaging.

According to the invention there is provided a method for providing a substantially dustfree interior to a sealed packaging container, comprising the steps of installing spacing means within the container such that the article or articles placed therein are separated from at least a portion of the interior surfaces of the container, characterised in that the spacing means are selected to provide no loose particulate matter; and by the step of coating the exposed non-article-contacting interior surface of the container with a layer of contact adhesive.

According to the invention there is further provided a dustless packaging container for packaging one or more articles comprising: a first frame member; a second frame member adapted to mate with the first frame member to form a sealable enclosed volume therewithin; spacing means for preventing the articles from contacting the interior surfaces of the first and second frame members; characterised by a layer of contact adhesive applied to at least some of the surfaces of the first and second frame members which are exposed within said enclosed volume.

As will be described hereinafter a contamination free package and a method of providing contamination free packages provides total protection for the exterior surfaces of products or components, from particulate contamination during transport and storage. The packaging container is especially suitable for use with optical and electronic products. A particular usage is in packaging for shipment and storage of photomask pellicles.

A preferred method of producing a dustless package includes placing a layer of adhesive material on the interior surface of a package or container at points which do not come into direct physical contact with the article being shipped. The adhesive layer is then provided with a peelable cover sheet having a non-adhesive exterior side. The cover sheet is installed upon the adhesive layer in such a manner that it may be easily removed when it is desired to expose the adhesive.

A preferred embodiment is a generalized packaging box utilized for transport and storage of articles. The generalized box is provided with spacer blocks or rings upon which the article is supported. In this manner, the surfaces of the article are separated from the interior wall surfaces of the container over a significant portion of the interior of the package. The non-contacting exposed surfaces of the container are then provided with a layer of contact adhesive. The layer is then provided with a peelable protective cover.

When the dustless package is to be utilized it is delivered to a sealed contamination free environment in conjection with the article to be shipped. The package is then cleaned by conventional means such as dust blasting by air or water jets and is ready for use. At the time that the package is ready for use, the peelable covers are removed and the contact adhesive surfaces are exposed. The article is then placed in the container such that it is supported on the spacer blocks or rings and an air space exists between the article and the adhesive surfaces. The adhesive then capture and retain particulate matter coming in contact with the adhesive and prevent the particulate matter from contaminating the surface of the article.

An advantage of the packaging container to be described hereinafter is that it significantly improves the minimization of particulate contamination to the surface of articles shipped.

Another advantage of the method to be described is that it is readily adapted to conventional shipping containers.

A further advantage of the method to be described is that it is extremely economical to implement.

It is still another advantage of the packaging container to be described in that the adhesive surfaces of the package may be maintained and protected up until the time that they are exposed, by peeling the covers, to protect the article.

Yet another advantage of the container to be described is that the freshly peeled adhesive layer presents a contamination free surface.

Dustless packaging containers and methods of packaging both embodying the invention will now be described, by way of example, with reference to the accompanying diagrammatic drawings in which:

Fig. 1 is a longitudinal cross sectional view of a dustless package according to the method of the present invention; and

Fig. 2 is a perspective view of the bottom member of the dustless package of Fig. 1.

Best mode of carrying out invention

The present invention is a method of providing a dustless contamination free container for transport and storage of articles. The dustless package is particularly utilized to protect the surfaces of optical and electronic components from contamination during shipment and storage. A particularly important usage of the method of the present invention is to protect the surface of photomask pellicle films.

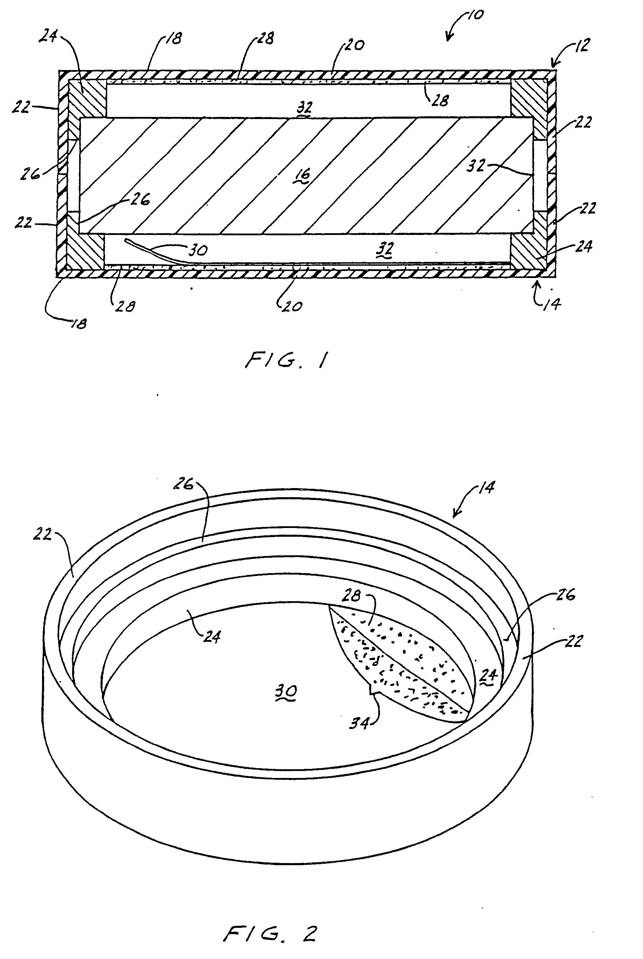

A dustless container according to the method of the present invention is shown in a longitudinal cross-sectional view in Fig. 1 and is designated by the general reference character 10. Although the method of the present invention is adaptable to containers of all sizes and shapes, the idealized dustless container 10 illustrated in Fig. 1 is shown as having an upper member 12 and a lower member 14 which is symmetrical about a horizontal plane with the upper member 12. The container 10 is also shown as enclosing a generalized article or product 16.

As is shown in Fig. 1, the idealized dustless container 10 has a rectangular longitudinal cross section. The upper member 12 and the lower member 14 both include a continuous integral exterior frame 18 which prevents the intrusion of matter from the outside environment to the interior of the container 10.

The exterior frame 18 includes lateral panels 20 on the top surface and the bottom surface of the container 10. Lateral panels 20 have planar surfaces on the interior of the container 10. The exterior frame 18 further includes longitudinal panels 22 which are formed integrally with the lateral panels 20 complete with frame. The shape of the longitudinal panels 22 is dependent upon the shape of the article 16 to be contained. In the case of a photomask pellicle package the longitudinal panels 22 will be curved so as to form a circular container 10 and will have only the height required to create an effective container.

The interior of the container 10 is provided with spacer blocks 24 to support the article 16 in such a position that it does not come into contact with the interior surface of the lateral panels 20. In the preferred embodiment, each spacer block 24 includes an extension in the nature of spacer ledge 26 which further supports the article 16 and prevents it from contacting the longitudinal panels 22.

The interior planar surface of the lateral panels 20 is provided with a layer of contact adhesive 28. The adhesive layer 28 is uniform over the entire interior surface of each lateral panel 20 to the extent that there is no exposed section of the lateral panel 20 which is not covered by the adhesive 28. The thickness of the adhesive layer 28 is sufficient to provide a continuous viable adhesive surface.

In some preferred embodiments the adhesive layer 28 is also applied to the exposed interior surfaces of the longitudinal panels 22. This application protects the side surfaces of the article 16 from contamination. However, in the embodiment shown, the article 16 is such that the side surfaces are less significant, such as with a pellicle, and it is less desirable to provide exposed adhesive 28 on the longitudinal surfaces 22.

In the preferred embodiment the adhesive layer 28 is separated from the interior of the container 10 by a peelable protective film 30. The protective film or cover 30 is utilized to prevent the adhesive layer 28 from drying or becoming contaminated prior to use. When it is time to utilize the container 10 the protective film or cover 30 is peeled back and removed to expose the adhesive layer 28. The freshly peeled adhesive is contamination free.

In the illustration of Fig. 1 the adhesive layer 28 on the upper member 12 is shown as totally exposed while the peelable film 30 is shown as still attached to the greater part of the layer 28 deposited on the lower member 14. In actual use, all segments of the adhesive layer 28 will be exposed.

An air space 32 is formed between the adhesive layer 28 and the article 16. This is caused by the support of the article 16 by the spacer blocks 24. The air space 32 prevents the surface of the article 16 from contacting the adhesive layer 28. The purpose of the adhesive layer 28 is to capture and retain particulate matter which may exist within the air space 32. This prevents particulate contamination to the surface of the article 16.

Fig. 2 illustrates the lower member 14 of the container 10 shown apart from the top member 12. This perspective view illustrates the particular shape of the lower member 14 selected for use in packaging a photomask pellicle. Since the pellicle is circular in shape with a support ring on the outside and a film or membrane stretched across the support ring, this sort of packaging is particularly appropriate. In this case it may be seen that the spacer block 24 is in the form of a continuous ring while the spacer ledge 26 is a portion of the ring extending longitudinally from the block 24. The dimensions of the elements are selected such that the pellicle fits tightly into the container and does not slide from side to side.

In this illustration it may be seen that the peelable cover 30 is partially peeled back to expose a section of the adhesive layer 28. As shown, the peelable cover 30 is provided with a grasping extension 34 at one edge so it may be easily grasped and removed from the adhesive layer 28. The removal of the protective film 30 may be accomplished either by manual or mechanical means.

The method of the present invention can be readily adapted to various types of containers utilized to package contamination sensitive materials. The initial step in the process is to fit or retrofit appropriate spacer blocks or rings into the container in such a manner that the articles are suspended within the container and do not come into contact with the interior container surfaces. The exposed interior surfaces, with which the article does not come into contact, are then provided with the adhesive layer. After the adhesive layer has been applied a protective film or cover is then placed over the adhesive layer to keep it in a pristine state until it is ready for use.

One modification of the method may be to coat the entire interior of the container with the adhesive layer. The adhesive may then be used to cement the spacer blocks 24 or rings in place.

One good method of accomplishing this is to apply precut double sided adhesive tape to the entire interior of the frame 18 and then to insert the spacer blocks 24.

There is no requirement restricting the application of adhesive to the lateral surfaces of the container. Any surface with which the product does not come into contact may be provided with adhesive. A maximum surface area of exposed adhesive acts to minimize the amount of particulate contamination which may be present in the air spaces and on the articles within the container.

The selection of material for dustless packages constructed according to the method of the present invention utilizes predominantly conventional materials. The materials utilized in the exterior frame must have a high surface integrity such that they do not provide any particulate contamination to the interior of the container. They must also be sufficiently strong and rigid to protect the contents from impact during transport stacking and storage. The materials and formation of materials must also be selected such that an adequate seal is created where the portions of the container are juxtaposed. This is important so that no contamination may enter the interior of the container from the surrounding environment.

The spacer blocks and ridges selected must also have high surface integrity, protect the product against impact, and prevent the product from coming into contact with any of the adhesive covered interior surfaces of the container. Any of numerous readily available commercial spacing materials, such as polyethylene, acrylics or aluminum, may be adequate for this purpose.

The preferred contact adhesive must also have various properties. Initially, it needs to be sufficiently sticky that it captures and retains as high a percentage as possible of particulate matter which may be trapped within the interior of the container. The adhesive must also have significant spatial integrity such that it will remain in position and will not break off or flake and become a contaminant in itself. Furthermore, the adhesive must be such that it will retain its integrity over long use and during transportation and storage conditions. It is imperative that the adhesive not dry up and flake or lose its capture and retention properties during usage. Acceptable contact adhesives include double sided pressure sensitive adhesives from various commercially available sources such as 3M Company's 3M447 adhesive.

The cover sheet or film 30 must be selected such that it is easily applied and removed from the adhesive layer 28 without adversely affecting the integrity of the adhesive layer. The dimensions of the cover sheet 30 are selected to match the dimensions of the exposed adhesive layer precisely and, in some embodiments, a grasping extension 34 is provided for easy removal. Since a chemical cleaning technique may be utilized on the container immediately prior to use it is important that the cover 30 protect the adhesive 28 from degradation during cleaning. A preferred material for the cover film 30 has been found to be mylar.

The dimensions of a container 10 according to the method of the present invention are entirely dependent upon the articles 16 to be contained within. Except as provided above, no unusual materials or procedures are required to implement the method.

The method of the present invention and the containers manufactured according to the method are expected to have widespread industrial utility within the electronic and optical fields. In particular, the method is adapted for immediate utility in the packaging of photomask pellicles. It is also expected that it will be rapidly adapted for usage regarding shipment and storage of materials which must be prevented from particulate contamination and which are difficult or impossible to adequately clean prior to usage.

Since the method of the present invention can be easily implemented as an addition to the present packaging techniques, it is expected to have widespread acceptance. Containers according to the method of the present invention will involve minimal additional manufacturing complexity or expense and thus should compete very favorably with prior art containers. For all of the above reasons, it is expected that the present invention will have significant industrial applicability at present and in the future.

## Claims

1. A method for providing a substantially dustfree interior to a sealed packaging container, comprising the steps of installing spacing means (24) within the container (10) such that the article or articles (16) placed therein are separated from at least a portion of the interior surfaces of the container (10), characterised in that the spacing means (24) are selected to provide no loose particulate matter; and by the step of coating the exposed non-article-contacting interior surface of the container (10) with a layer of contact adhesive (28).

2. The method of Claim 1 characterised in that the spacing means (24) are semirigid blocks formed to conform to the outside shape of the articles (16) being contained.

3. The method of any preceding claim characterised in that the article (10) to be contained is a circular photomask pellicle and the spacing means (24) are selected to be upper and lower support rings.

4. The method of any preceding claim characterised by the step of providing a peelable cover (30) over the contact adhesive (28), the peelable cover (30) being adapted such that it protects the adhesive (28) while in place and further being adapted for easy removal at the time that articles (16) are to be placed within the container (10).

5. A dustless packaging container for packaging one or more articles comprising: a first frame member; a second frame member adapted to mate with the first frame member to form a sealable enclosed volume therewithin; spacing means for preventing the articles from contacting the interior surfaces of the first and second frame members; characterised by a layer of contact adhesive (28) applied to at least some of the surfaces of the first and second frame members which are exposed within said enclosed volume.

6. The dustless container of Claim 5 characterised in that the spacing means (24) includes semirigid blocks, formed to mate with the exterior portions of the enclosed articles (16), bonded to the interior surfaces of the first and second frame members.

7. The dustless container of Claim 5 or of Claim 6 characterised by peelable covers (30) applied over the exposed portion of said contact adhesive (28) so as to protect said adhesive (28) from contamination prior to use, said peelable covers (30) being adapted for easy removal to expose said adhesive immediately prior to insertion of articles (16) into the container.

8. The method or container of any preceding claim characterised in that said contact adhesive (28) is selected to be resistant to drying, degradation and saturation during storage and shipment conditions.

9. The method or container of any preceding claim characterised in that the total exposed surface area of the spacing means (24) is less than the total surface area of the exposed interior surface of the container (10).

10. The method of Claim 4 or the container of Claim 7 characterised in that said peelable cover (30) is further provided with a grasping extension such that it may readily grasped by manual or mechanical means and removed from the adhesive.

11. The method or container of any preceding claim characterised in that said contact adhesive is in the form of double-sided adhesive tape.

## Patentansprüche

1. Verfahren zum Herstellen eines im wesentlichen staubfreien Inneren für einen dichten Verpackungsbehälter mit den Verfahrensschritten des Einbringens von Abstandshaltemitteln (24) innerhalb des Behälters (10), so daß der oder die in diesen gelegten Gegenstände (16) von wenigstens einem Abschnitt der inneren Oberfläche des Behälters (10) entfernt sind, dadurch gekennzeichnet, daß die Abstandshaltemittel (24) so vorbestimmt sind, daß sie keine lose korpuskulare Substanz schaffen, und durch den Verfahrensschritt des Beschichtens der nicht den Gegenstand berührenden inneren Oberfläche des Behälters (10) mit einer Schicht eines Kontaktklebers (28).

2. Verfahren nach Anspruch 1, dadurch gekennzeichnet, daß die Abstandshaltemittel (24) halbstarre Klötze sind, die so ausgestaltet sind, daß sie der äußeren Gestalt der einzulegenden Gegenstände (16) entsprechen.

3. Verfahren nach einem der vorstehenden Ansprüche, dadurch gekennzeichnet, daß der einzulegende Gegenstand (16) ein kreisförmiges Photomaskenhäutchen ist und daß die Abstandshaltemittel (24) als obere und untere Stützringe ausgewählt sind.

4. Verfahren nach einem der vorstehenden Ansprüche, gekennzeichnet durch den Verfahrensschritt des Vorsehens einer abziehbaren Abdeckung (30) über dem Kontaktkleber (28), wobei die abziehbare Abdeckung (30) so angepaßt ist, daß sie, solange sie an ihrem Platz befindlich ist, den Kontaktkleber (28) schützt, und weiterhin zum leichten Entfernen zu der Zeit geeignet ist, wenn Gegenstände (16) in den Behälter (10) einzulegen sind.

5. Staubfreier Behälter zum Einpacken von einem oder mehreren Gegenständen mit einem ersten Rahmenelement, mit einem zweiten Rahmenelement, das dazu geeignet ist, mit dem ersten Rahmenelement zusammenzuwirken, um ein abdichtendes umschlossenes Volumen in diesem zu schaffen, und mit Abstandshaltemitteln, um zu verhindern, daß die Gegenstände die inneren Oberflächen des ersten und zweiten Rahmenelementes berühren, dadurch gekennzeichnet, daß eine Schicht Kontaktkleber (28) auf wenigstens einige der Oberflächen des ersten und zweiten Rahmenelementes aufgetragen ist, die in dem umschlossenen Volumen freigelegt sind.

6. Staubfreier Behälter nach Anspruch 5, dadurch gekennzeichnet, daß die Abstandshaltemittel (24) halbstarre Klötze umfaßt, die so gestaltet sind, daß sie mit äußeren Abschnitten der umschlossenen Gegenstände (16) zusammenwirken und an die inneren Oberflächen des ersten und zweiten Rahmenelementes verbunden sind.

7. Staubfreier Behälter nach Anspruch 5 oder Anspruch 6, gekennzeichnet durch abziehbare Abdeckungen (30), die über den freigelegten Abschnitt des besagten Kontaktklebers (28) angebracht sind, um den Kleber (28) vor der Kontamination vor seinem Einsatz zu schützen, wobei die abziehbaren Abdeckungen (30) für eine einfache Entfernung geeignet sind, um den Kleber unmittelbar vor dem Einlegen der Gegenstände (16) in den Behälter freizulegen.

8. Verfahren oder Behälter nach einem der vorstehenden Ansprüche, dadurch gekennzeichnet, daß der ausgewählte Kontaktkleber (28) widerstandsfähig gegenüber Austrocknen, Verschlechterung und Sättigung unter Lagerungs- und Transportbedingungen ist.

9. Verfahren oder Behälter nach einem der vorstehenden Ansprüche, dadurch gekennzeichnet, daß die gesamte freigelegte Oberfläche der Abstandshaltemittel (24) kleiner als die Gesamtoberfläche der freigesetzten inneren Oberfläche des Behälters (10) ist.

10. Verfahren nach Anspruch 4 oder Behälter nach Anspruch 7, dadurch gekennzeichnet, daß die abziehbare Abdeckung (30) mit einem Greifansatz versehen ist, so daß sie ohne weiteres durch manuelle oder mechanische Mittel gegriffen und von dem Kleber entfernt werden kann.

11. Verfahren oder Behälter nach einem der vorstehenden Ansprüche, dadurch gekennzeichnet, daß der Kontaktkleber ein doppelseitig klebendes Band ist.

**Revendications**

1. Procédé pour pourvoir un récipient d'emballage scellé d'un intérieur substantiellement exempt de poussière, comprenant les opérations d'installer à l'intérieur du récipient (10) des moyens d'espacement (24) tels que l'article ou les articles (16) placés dedans sont séparés d'au moins une partie des surfaces intérieures du récipient (10), caractérisé en ce que les moyens d'espacement (24) sont choisis pour ne fournir aucune matière particulaire libre; et par l'opération de couvrir la surface intérieure exposée du récipient (10) non en contact avec l'article d'une couche d'adhésif par contact (28).

2. Procédé selon la revendication 1, caractérisé en ce que les moyens d'espacement (24) sont des blocs semirigides formés pour se conformer à la silhouette extérieure des articles (16) contenus.

3. Procédé selon l'une quelconque des revendications précédentes, caractérisé en ce que l'article (10) à contenir est une pellicule circulaire photomasque et les moyens d'espacement (24) sont choisis pour être des anneaux de support supérieur et inférieur.

4. Procédé selon l'une quelconque des revendications précédentes, caractérisé par l'opération de prévoir un couvercle pelable (30) sur l'adhésif par contact (28), ce couvercle pelable (30) étant adapté pour qu'il protège l'adhésif (28) quand il est en place et étant adapté en plus à un enlèvement facile au moment où les articles (16) sont à placer à l'intérieur du récipient (10).

5. Récipient d'emballage exempt de poussière pour l'emballage d'un ou de plusieurs articles comprenant: un premier élément; un second élément adapté pour s'ajuster avec le premier élément pour former entre eux un volume fermé pouvant être scellé, des moyens d'espacement pour empêcher les articles de venir en contact avec les surfaces intérieures du premier et du second élément, caractérisé par une couche d'adhésif par contact (28) appliquée à certaines au moins des surfaces du premier et du second élément qui sont exposées à l'intérieur du volume fermé.

6. Récipient exempt de poussière selon la revendication 5, caractérisé en ce que les moyens d'espacement (24) comprennent des blocs semirigides formés pour s'assembler avec des parties extérieures des articles inclus (16), réunis aux surfaces intérieures du premier et du second élément.

7. Récipient exempt de poussière selon la revendication 5 ou la revendication 6, caractérisé par des couvercles pelables (30) appliqués sur les parties exposées dudit adhésif par contact (28) de manière à protéger cet adhésif (28) de toute contamination avant usage, ces couvercles pelables (30) étant adaptés pour permettre un enlèvement facile afin d'exposer cet adhésif immédiatement avant l'introduction des articles (16) à l'intérieur du récipient.

8. Procédé ou récipient selon l'une quelconque des revendications précédentes, caractérisé en ce que ledit adhésif par contact (28) est sélectionné pour être résistant au séchage, à la dégradation et à la saturation pendant le stockage et dans les conditions d'expédition.

9. Procédé ou récipient selon l'une quelconque des revendications précédentes, caractérisé en ce que l'aire de la surface totale exposée des moyens d'espacement (24) est inférieure à l'aire de la surface totale de la surface intérieure exposée du récipient (10).

10. Procédé selon la revendication 4, ou conteneur selon la revendication 7, caractérisé en ce que le couvercle pelable (30) est pourvu en outre d'un prolongement de préhension afin qu'il puisse être facilement saisi par un moyen manuel ou mécanique et retiré de l'adhésif.

11. Procédé ou récipient selon l'une quelconque des revendications précédentes, caractérisé en ce que l'adhésif par contact est sous forme d'un ruban adhésif du type à double-face.

FIG. 1

FIG. 2